**Europäisches Patentamt**

(19) **European Patent Office**

**Office européen des brevets**

(11) Numéro de publication: **0 117 812**
**B1**

(12) **FASCICULE DE BREVET EUROPÉEN**

(45) Date de publication du fascicule du brevet:
**04.11.87**

(21) Numéro de dépôt: **84400345.9**

(22) Date de dépôt: **20.02.84**

(51) Int. Cl.⁴: **F 16 J 15/02**, B 64 D 43/00

(54) Joint d'étanchéité pour plateau d'électronique d'avion.

(30) Priorité: **23.02.83 FR 8302908**

(43) Date de publication de la demande:
**05.09.84 Bulletin 84/36**

(45) Mention de la délivrance du brevet:
**04.11.87 Bulletin 87/45**

(84) Etats contractants désignés:
**BE CH DE GB IT LI NL SE**

(56) Documents cité:
**DE-A-2 558 047**
**FR-A-2 347 587**
**GB-A-2 064 022**
**US-A-4 044 515**

(73) Titulaire: **VIBRACHOC, 216 Les Bureaux de la Colline de Saint Cloud, F-92213 Saint Cloud (FR)**

(72) Inventeur: **Le Pierres, Gildas, Rue des Rochettes D'Huisson Longueville, F-91500 La Ferte Alais (FR)**

(74) Mandataire: **Weinmiller, Jürgen, Lennéstrasse 9 Postfach 24, D-8133 Feldafing (DE)**

LIBER, STOCKHOLM 1987

EP 0 117 812 B1

## Description

La presente invention a trait à un joint d'étanchéité pour un plateau d'électronique d'avion.

Comme on le sait, un plateau d'électronique d'avion est un plateau disposé généralement horizontalement sur un rayonnage dans un avion et qui est destiné à supporter un appareil ou équipement électronique. A cette fin, le plateau comporte en général des glissières permettant la mise en place par coulissement du boîtier de l'appareil ou équipement électronique, dont la face inférieure glisse sur le plateau pendant le mouvement de mise en place. Comme il est nécessaire de prévoir un refroidissement pour les composants électroniques à l'interieur de l'appareil ou équipement, le plateau comporte un orifice permettant le passage de l'air frais qui traverse l'appareil électrique par des ouvertures pratiquées dans le haut et le bas de celui-ci.

Pour le bon fonctionnement du plateau, il est necéssaire d'assurer l'étanchéité entre le fond du boîtier mis en place sur le plateau et le plateau lui-même, autour du passage et de l'orifice, et l'on prevoit à cet effet un joint d'étanchéité de forme continue, porté par le plateau et agencé de façon à se déformer lors de la mise en place de l'appareil et à s'appliquer contre la face inférieure du boîtier. On comprend que le joint doit être facilement interchangeable.

Par ailleurs, le débit d'air provenant du système général de refroidissement doit être ajusté et l'on prévoit donc d'utiliser, à cet effet, un diaphragme c'est-à-dire une plaque comprenant une ou plusieurs ouvertures de surface bien déterminée, ladite plaque venant se mettre en place dans l'orifice proprement dit du plateau.

Là également, il est nécessaire non seulement d'assurer l'interchangeabilité de ce diaphragme, mais également d'établir l'étanchéité au niveau de son raccordement au plateau proprement dit et l'on a déjà prévu d'utiliser un seul et même joint pour assurer d'une part l'étanchéité contre la face inférieure du boîtier de l'appareil et, d'autre part, l'étanchéité entre le diaphragme et le plateau d'électronique d'avion.

On connaît selon le document GB-A-2 064 022, un tel joint qui s'appuie sur le pourtour de l'orifice du plateau et qui comporte une gorge pratiquée dans le corps du joint, à un niveau bien entendu inférieur à celui portant la surface du joint qui s'applique contre la face inférieure du boîtier, et dans laquelle pénètre le diaphragme.

On connaît également, selon le document US 4 044 515, un joint comportant deux gorges, l'une extérieure pour fixer le joint sur le bord du plateau et l'autre intérieure recevant le diaphragme.

Ces deux solutions nécessitent la fabrication de joints complexes et un grand respect des tolérances, notamment au niveau des gorges. En outre, une désinsertion accidentelle du diaphragme ne peut pas être exclue.

La présente invention se propose de remédier à ces inconvénients et de fournir un joint d'étanchéité pour plateau d'électronique d'avion qui soit de fabrication et de montage simples et qui supprime tout risque de désinsertion du joint ou du diaphragme.

L'invention a pour objet un joint d'étanchéité pour plateau d'électronique d'avion, de forme continue, destiné à être mis en place à la périphérie d'un orifice d'un plateau d'électronique d'avion de façon, d'une part, à assurer l'étanchéité entre le plateau et la face inférieure d'un boîtier d'appareil ou d'équipement, et d'autre part, à assurer l'étanchéité entre le plateau et un diaphragme disposé dans l'orifice du plateau, comportant, en section, une partie d'étanchéité disposée du côté le plus interne de l'orifice et émergeant au-dessus du plateau pour pouvoir entrer en contact d'étanchéité avec un boîtier, une partie centrale de liaison disposée à l'intérieur de l'orifice, caractérisé en ce qu'il comporte une partie destinée à être pincée entre la face inférieure de la semelle du plateau et la face supérieure du diaphragme, ce diaphragme étant fixé directement contre le plateau par des moyens de fixation convenables.

Dans une forme de réalisation préférée, la partie destinée à être pincée présente une épaisseur supérieure à la partie de liaison qui la raccorde à la partie d'étanchéité émergente de façon à permettre un blocage de forme positif dans le plan du plateau et éviter une extraction du joint. Ainsi, la partie de liaison peut par exemple former une gorge orientée vers la face supérieure du plateau et dans laquelle peut pénétrer un rebord convenable de l'orifice du plateau.

De préférence, dans cette forme de réalisation, la gorge est nettement plus large que le rebord de façon à éloigner la partie d'étanchéité émergente dudit rebord.

La largeur de ladite gorge peut être avantageusement telle que la partie émergente du joint puisse y trouver une place lorsqu'elle est escamotée au moment de la mise en place du boîtier de l'appareil ou équipement électronique sur le plateau.

De préférence, la partie d'étanchéité émergente présente deux lèvres entre lesquelles s'étend une gorge destinée à servir de réserve à un produit lubrifiant.

Dans le cas où l'on réalise le joint de l'invention avec une grande largeur, on peut avantageusement insérer une ou plusieurs languettes métalliques, par exemple la face inférieure, pour éviter un décollement lors de l'enfichage ou du désenfichage du boîtier.

D'autres avantages et caractéristiques de l'invention apparaîtront à la lecture de la description suivante, faite d'titre d'exemple non limitatif et se référant au dessin annexé dans lequel :

La figure 1 représente une vue en coupe d'un joint selon l'invention, monté sur le plateau.

La figure 2 représente une vue du dessus du joint.

La figure 3 représente une vue en coupe d'un joint de grande largeur selon l'invention.

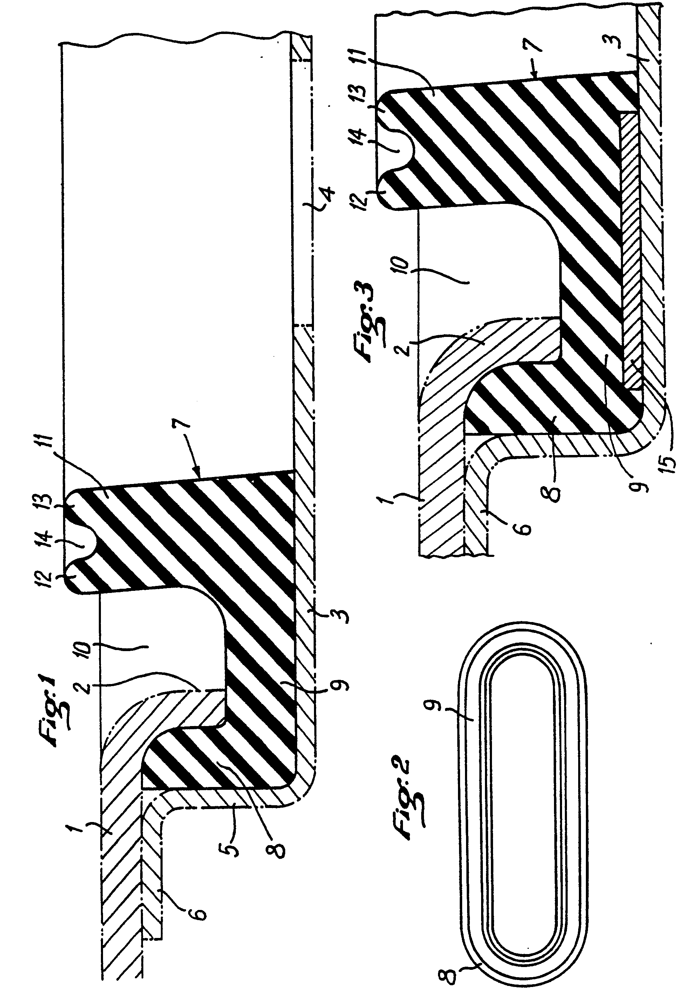

On se réfère tout d'abord aux figures 1 et 2.

Sur la figure 1, on a représenté la semelle, c'est-à-dire la partie supérieure d'un plateau d'électronique d'avion 1, constituant une surface sur laquelle vient se disposer la partie inférieure plane d'un boîtier d'appareil. Dans ce plateau est pratiqué un orifice de forme oblongue dont le bord est recourbé en un rebord 2 orienté vers le bas. Le diaphragme 3 muni de ses passages calibrés 4 présente un bord relevé 5 qui vient se disposer concentriquement et à l'extérieur du rebord 2 et qui se poursuit par un second rebord plat 6, susceptible de venir s'appliquer contre la face inférieure du plateau 1 pour y être fixé contre ladite semelle par des moyens convenables tels que par exemple des vis (non représentées).

Le joint d'étanchéité selon l'invention, désigné dans son ensemble par 7, présente une section transversale vue sur la figure 1 avec une première partie 8 susceptible d'être contenue dans l'espace disposé entre les rebords 2 et 5 et, dans le sens vertical, entre le diaphragme 3 et le plateau 1. La partie 8 est, à l'état de repos, d'une hauteur quelque peu supérieure à la distance verticale séparant le plateau 1 du diaphragme 3 de façon à être comprimée au montage dans le sens vertical. En outre, elle forme un talon s'opposant à une extraction du joint dans la direction horizontale vers la droite de la figure. On comprend que cette partie 8 assure ainsi une parfaite étanchéité entre le diaphragme 3 et le plateau 1.

La partie 8 se poursuit vers l'intérieur de l'orifice de plateau par une partie de liaison 9 de plus faible épaisseur, au-dessus de laquelle le joint forme une gorge 10 dont la largeur est nettement supérieure à l'epaisseur du rebord 2.

Cette gorge 10 est délimitée par la partie d'étanchéité 11 qui se dresse sur une assez grande hauteur de façon à posséder une partie supérieure émergeant, comme on le voit, au-dessus de la surface supérieure du plateau 1. Cette extrémité présente deux lèvres concentriques 12, 13 formant entre elles une gorge 14 qui peut avantageusement recevoir un lubrifiant.

On comprend que lorsque le boîtier de l'appareil est enclenché, c'est-à-dire posé par glissement sur le plateau 1, il vient repousser le joint par ses lèvres 12 et 13 qui assurent l'étanchéité contre la face inférieure du boîtier.

Par ailleurs, on comprend que, lorsque la partie de joint 11 est déformée par exemple sous l'effet d'un glissement en translation du boîtier de la droite vers la gauche du dessin, cette partie 11 peut s'effacer en tant que de besoin dans la gorge 10 où elle trouve la place suffisante.

On a ainsi réalisé un joint d'étanchéité convenant parfaitement à l'usage recherché et présentant une forme relativement simple, facile à fabriquer par exemple par moulage.

En se référant à la figure 3, on voit une variante de l'invention dans laquelle, en raison de dimensions plus importantes, le joint 7 a reçu, à sa face inférieure, un insert 15 en alliage léger sous forme d'une bague oblongue. Cette bague peut avoir été mise en place par surmoulage du joint sur la bague. Elle s'étend de préférence par son extrémité externe jusqu'au niveau de la partie 6 et on comprend qu'elle joue un rôle de raidissement permettant d'éviter, par exemple lors de la mise en place d'un boîtier qui agit sur la partie 11, une sorte de décollement de ladite partie 11 loin du diaphragme 3 de sorte que ladite partie 11 est contrainte de se replier en trouvant sa place obligatoirement dans la gorge 10.

**Revendications**

1. Joint d'étanchéité pour plateau d'électronique d'avion de forme continue, destiné à être mise en place à la périphérie d'un orifice d'un plateau d'électronique d'avion (1) de façon, d'une part, à assurer l'étanchéité entre le plateau et la face inférieure d'un boîtier d'appareil ou d'équipement, et d'autre part, à assurer l'étanchéité entre le plateau (1) et un diaphragme (3) disposé dans l'orifice du plateau, comportant, en section, une partie d'étanchéité (11) disposée du côté le plus interne de l'orifice et émergeant au-dessus du plateau (1) pour pouvoir entrer en contact d'étanchéité avec un boîtier, une partie centrale de liaison (9) disposée à l'intérieur de l'orifice, caractérisé en ce qu'il comporte une partie (8) destinée à être pincée entre la face inférieure de la semelle du plateau (1) et la face supérieure du diaphragme (3), ce diaphragme (3) étant fixé directement contre le plateau par des moyens de fixation convenables.

2. Joint selon la revendication 1, caractérisé en ce que l'épaisseur de la partie de liaison (9) est inférieure à l'épaisseur de la partie (8) destinée à être pincée.

3. Joint selon la revendication 2, caractérisé en ce que la partie destinée à être pincée (8) présente une forme de talon coopérant pour un blocage de forme positif avec un rebord (2) du bord de l'orifice de plateau.

4. Joint selon l'une quelconque des revendications 1 à 3, caractérisé en ce que ladite partie de liaison forme une gorge de dimension suffisante pour que la partie émergente (11) du joint puisse y trouver une place lorsqu'elle est escamotée.

5. Joint selon l'une quelconque des revendications 1 à 4, caractérisé en ce que la partie d'étanchéité (11) présente deux lèvres (12, 13) entre lesquelles s'étend une gorge (14).

**Patentansprüche**

1. Dichtung für Flugzeug-Elektroniktafel durchgehender Form, die am Umriß einer Öffnung einer Flugzeug-Elektroniktafel (1) so angeordnet werden soll, daß sie einerseits die Dichtheit zwischen der Tafel und der Unterseite eines Geräte- oder Ausrüstungsgehäuses und andererseits die Dichtheit zwischen der Tafel (1) und einer Membran (3) bewirkt, die in der Öffnung der Tafel angeordnet ist, wobei die Dichtung im Schnitt einen Dichtungsbereich (11) auf der innersten Seite der Öffnung, der über die Tafel (1) vorsteht, um in Dichtungskontakt mit einem Gehäuse zu treten, und einen zentralen Verbindungsbereich (9) im Inneren der Öffnung aufweist, dadurch gekennzeichnet, daß sie einen Bereich (8) aufweist, der zwischen die Unterseite der Tafel (1) und die Oberseite der Membran (3) geklemmt werden soll, wobei die Membran (3) durch geeignete Befestigungsmittel direkt an der Tafel befestigt ist.

2. Dichtung nach Anspruch 1, dadurch gekennzeichnet, daß die Dicke des Verbindungsbereichs (9) geringer ist als die Dicke des Bereichs (8), der eingeklemmt werden soll.

3. Dichtung nach Anspruch 2, dadurch gekenzeichnet, daß der einzuklemmende Bereich (8) die Form eines Absatzes hat, der für eine positive Blockierung mit einer Kante (2) des Rands der Tafelöffnung zusanmmenwirkt.

4. Dichtung nach einem beliebigen der Ansprüche 1 bis 3, dadurch gekennzeichnet, daß der Verbindungsbereich eine Kehle ausreichender Abmessung bildet, damit der vorstehende Bereich (11) der Dichtung in ihr einen Platz findet, wenn er zurückgeklappt ist.

5. Dichtung nach einem beliebigen der Ansprüche 1 bis 4, dadurch gekennzeichnet, daß der Dichtungsbereich (11) zwei Lippen (12, 13) aufweist, zwischen denen sich eine Kehle (14) erstreckt.

**Claims**

1. A seal for an airplane electronic board of continuous form, intended to be placed at the periphery of an orifice of an airplane electronic board (1), such as to, on the one hand, ensure sealing between the board and the lower surface of an apparatus or equipment housing and, on the other hand, to ensure the sealing between the board (1) and a diaphragm (3) disposed in the orifice of the board, comprising, in section, a sealing portion (11) disposed on the innermost side of the orifice and emerging above the board (1) for being able to enter into sealing contact with a housing, a central connection portion (9) disposed inside the orifice, characterized in that it comprises a portion (8) intended to be squeezed between the lower surface of the bottom of the board (1) and the upper surface of the diaphragm (3), this diaphragm (3) being directly applied against the board by suitable fixing means.

2. A seal according to claim 1, characterized in that the thickness of the connection portion (9) is smaller than the thickness of the portion (8) intended to be squeezed.

3. A seal according to claim 2, characterized in that the portion intended to be squeezed (8) presents the form of a heel cooperating for a positive blocking with an edge (2) of the rim of the orifice of the board.

4. A seal according to any one of claims 1 to 3, characterized in that said connection portion forms a throat of sufficient dimensions for the emerging portion (11) of the seal to find a place therein when it is retracted.

5. A seal according to any one of claims 1 to 4, characterized in that the sealing portion presents two lips (12, 13) with a throat (14) extending between them.

Fig.1

Fig.2

Fig.3